## Europäisches Patentamt

(19) **European Patent Office**

**Office européen des brevets**

(11) Numéro de publication: **0 104 988**

**B1**

(12) # FASCICULE DE BREVET EUROPÉEN

(45) Date de publication du fascicule du brevet:
08.04.87

(51) Int. Cl.⁴: **H 04 B 14/06**

(21) Numéro de dépôt: **83401807.9**

(22) Date de dépôt: **15.09.83**

(54) **Codeur de type delta-sigma, à double intégration et applications de ce codeur à une voie de transmission de type MIC et à la mesure de tensions continues.**

(30) Priorité: **21.09.82 FR 8215857**

(43) Date de publication de la demande:
**04.04.84 Bulletin 84/14**

(45) Mention de la délivrance du brevet:
**08.04.87 Bulletin 87/15**

(84) Etats contractants désignés:
**DE GB IT**

(56) Documents cité:
**FR-A-2 462 062**

**IEEE JOURNAL OF SOLID-STATE CIRCUITS, vol. SC-12, no. 6, décembre 1977, New York (US), B.J. HOSTICKA et al.: "MOS sampled data recursive filters using switched capacitor integrators", pages 600-608**
**IEEE JOURNAL OF SOLID-STATE CIRCUITS REVIEW OF THE ELECTRICAL COMMUNICATION LABORATORIES, vol. 29, nos. 5-6, mai-juin 1981, Tokyo (JP), A. IWATA et al.: "PCM single-channel CODEC LSIs with CMOS technologies", pages 493-509**
**PATENT ABSTRACTS OF JAPAN, vol. 5, no. 78 (E-58) (750), 22 mai 1981**

(73) Titulaire: **Senn, Patrice, 13, Grande Rue, F-38000 Grenoble (FR)**

(72) Inventeur: **Senn, Patrice, 13, Grande Rue, F-38000 Grenoble (FR)**

(74) Mandataire: **Mongrédien, André, c/o BREVATOME 25, rue de Ponthieu, F-75008 Paris (FR)**

LIBER, STOCKHOLM 1987

**Description**

La présente invention concerne un codeur analogique-numérique, de type Delta-Sigma, à double intégration. Cette invention s'applique au codage de signaux et, plus particulièrement, à la transmission de signaux sur des voies de communication de type MIC (Modulation d'Implulsions Codées); elle s'applique aussi à la mesure de tensions continues.

Les circuits intégrés sur substrat et notamment les circuits de traitements numériques de signal, sont de plus en plus nombreux et complexes. La qualité du traitement du signal obtenu grâce à ces circuits, ainsi que les performances technologiques (taille des circuits, faible puissance dissipée, fiabilité...) permettent d'envisager continuellement de nouvelles utilisations de ces circuits dans des domaines qui, jusque là, étaient réservés aux circuits analogiques. Toutefois, il se pose actuellement un problème difficile à résoudre qui est celui de l'interface entre la partie analogique et la partie numérique d'un ensemble fonctionnel. Si les techniques de traitements numériques ont évolué très rapidement, il n'en est pas de même pour les interfaces analogiques-numériques.

L'intégration sur substrat, des composants de codeurs analogiques-numériques classiques, est la plupart du temps une solution très coûteuse; les techniques d'intégration à grande échelle leur sont difficilement applicables.

Il est connu de surmonter cet inconvénient en réalisant un codeur analogique-numérique "à mise en forme du spectre de bruit", tel qu'un codeur de type Delta-Sigma: Ce type de codeur est décrit, notamment dans l'article de Tewksbury and Hallock intitulé "Oversampled, Linear predictive and Noise-Shoping Coders of Order N > 1" paru dans la revue "IEEE Transactions on Circuit and System" Vol. CAS-25 n°7, Juillet 1978; il est aussi décrit dans le brevet français FR-A- 2 462 062 publié le 6. Février 1981, au nom de M. Jean-Pierre PETIT, intitulé "Codeur delta-sigma à double intégration analogique et découdeur delta-sigma à double intégration numérique". Les codeurs à mise en forme du spectre de bruit, de type delta-sigma, permettent de réduire au minimum le nombre des éléments qui doivent fonctionner en régime linéaire et qui effectuent la plus grande partie des traitements sous forme numérique. L'intérêt de ces codeurs est qu'ils permettent de bénéficier au maximum des techniques d'intégration des circuits numériques. La partie analogique peut être soit réalisée à partir d'éléments discrets, soit intégrée sur un circuit analogique annexe, soit même intégrée directement sur le circuit de traitement numérique, si la technologie le permet. Un autre avantage de ce type de codeurs vient du fait que lorsqu'ils utilisent une quantification sur un seul élément binaire, pour la conversion numérique, ils sont très peu sensibles aux perturbations de transmission dans un environnement très bruité, tel qu'un milieu industriel par exemple. Le principe de la mise en forme du spectre du bruit utilisé dans ces codeurs les rend de plus très performants dans les mesures de tension continue à faible débit.

Les codeurs analogiques-numériques de type delta-sigma à double intégration, sont des codeurs particuliers dont la structure et le principe de fonctionnement, découlent directement de la structure et du fonctionnement des codeurs à mise en forme du spectre de bruit.

Le principe d'un codeur à mise en forme du spectre de bruit, est connu depuis longtemps; une étude très approfondie de ce type de codeur est donnée dans l'article "Oversampled, Linear predictive and Hoise-Shoping coders of order N > 1" de TEWKSBURY et HALLOCK paru dans la revue "IEEE transactions" Vol. CAS 25 n°7 Juillet 1978.

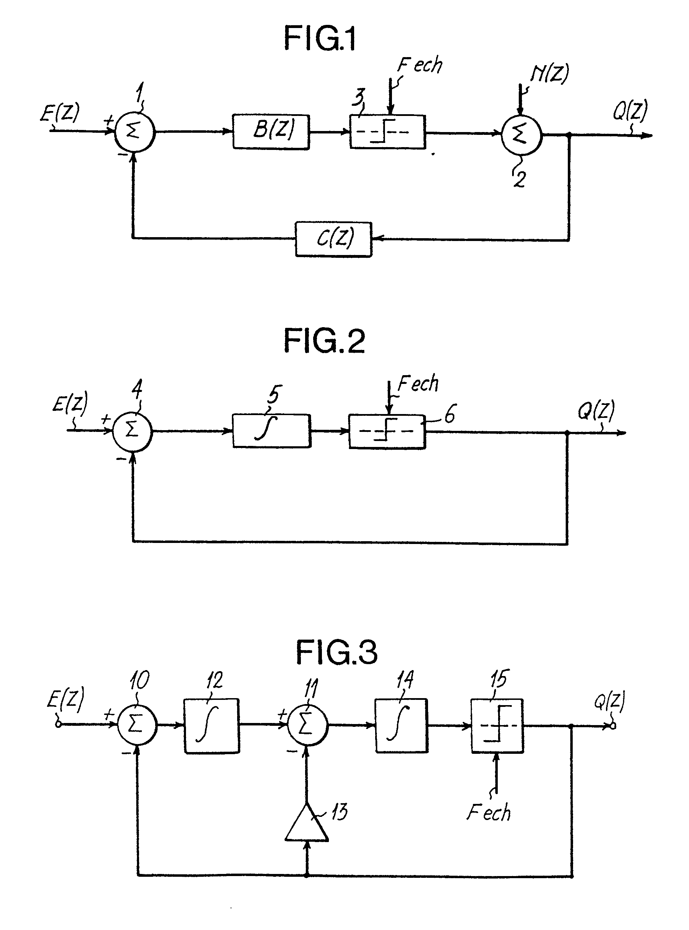

- La figure 1 représente schématiquement un codeur à mise en forme de spectre de bruit. Ce codeur comprend des additionneurs 1, 2, et un quantificateur 3, qui permet d'échantillonner à une fréquence Fech, un signal E(Z) d'entrée. Il comprend aussi un filtre à réaction B(Z) et, dans une boucle de contre-réaction reliant la sortie du codeur à l'une des entrées du comparateur 1, un filtre de contre-réaction C(Z). Le signal de sortie est référencé Q(Z), tandis que M(Z) représente le bruit propre à tout convertisseur analogique-numérique; ce bruit apparaît lors de toute opération de quantification dans ce type de conversion. On suppose que le signal d'entrée $E_Z$ est déjà échantillonné à la fréquence Fech et, dans la suite de l'exposé, on utilise la variable d'état Z pour représenter les différents signaux.

On sait que le bruit de quantification M(Z) est d'autant plus faible que la quantification est plus fine, c'est-à-dire lorsque le nombre d'éléments binaires en sortie du décodeur est plus élevé. L'intérêt de ce codeur réside dans le fait qu'il peut fonctionner avec une quantification très grossière. La suite de la description ne concerne que les quantificateurs à deux niveaux (un élément binaire).

Le signal de sortie Q(Z) du codeur, s'exprime facilement à partir de E(Z) et de N(Z). de la manière suivante:

$Q(Z) = B(Z). (E(Z) - Q(Z). C(Z)) + N(Z)$ soit: $Q(Z) = E(Z). B(Z)/(1 + B(Z).C(Z) + N(Z)/(1+B(Z).C(Z))$ B(Z) et C(Z) représentent les fonctions de transfert des filtres à réaction et contre-réaction.

On dit que l'on a un codeur à mise en forme du spectre de bruit quand B(Z) et C(Z) vérifient les équations suivantes:

$B(Z)/(1 + B(Z).C(Z) ) = Z^{-P}$ (déphaseur pur) $1 + B(Z).C(Z) = H(Z)$

Il a été démontré, notamment dans l'article de Tewksburry and Hallock, mentionné plus haut, qu'une fonction $B_Z$ de la forme $1/(1-Z^{-1})^n$, relative à un intégrateur numérique d'ordre n, minimise la puissance de bruit dans une bande de fréquence B de signal (s'étendant de Zéro à B). Lorsque cette fonction est mise en oeuvre, le codeur à mise en forme du spectre de bruit est alors un codeur de type delta-sigma, dont l'ordre est donné par la puissance n de la fonction B(Z).

- La figure 2 représente schématiquement un codeur delta-sigma d'ordre 1. Ce codeur qui est aussi décrit dans l'article précité, comprend un additionneur qui reçoit sur son entrée un signal E(Z) déjà échantillonné, et

2

qui reçoit sur une autre entrée, le signal de sortie Q(Z). Ce codeur comprend aussi un intégrateur 5 constitué de façon connue, par un circuit à amplificateur opérationnel; la sortie de cet intégrateur est reliée à l'entrée d'un quantificateur 6, recevant sur une entrée de commande un signal d'échantillonnage à une fréquence Fech. Dans le cas de ce codeur à mise en forme du bruit d'ordre 1, on a:

$B(Z) = Z^{-1}/(1-Z^{-1})$

dans cette relation B(Z) est la fonction de transfert en Z d'un intégrateur associé à un bloqueur d'ordre 0. Dans ce cas, C(Z) = 1 et il en résulte:

$Q(Z) = Z^{-1}. E(Z) + (1-Z^{-1}) Q^Z.$

Dans cette relation, si l'on fait abstraction de $Z^{-1}$ x E(Z) et qui correspond à un simple retard, on obtient bien une équation de la forme H(Z) = 1 + B(Z). C(Z) mentionnée plus haut.

L'emploi de codeurs delta-sigma comme échantillonneur dans un convertisseur analogique-MIC a été proposé dans l'article "A single Channel PCM Codec" par J.D. EVERARD. IEEE. ICC 1978. Toronto Juin 1978.

Pour le codeur décrit dans cet article, la fréquence d'échantillonnage est de 2.048 MHz. Cette fréquence ne permet pas d'obtenir le rapport signal/bruit imposé par les normes, notamment aux faibles niveaux. Il a été proposé également (cf. "Improvements to delta sigma modulators when used for PCM encoding" de J.D. EVERARD dans Electronics Letters. 22 Juillet 1976. vol. 12. n° 15 page 379) d'augmenter le rapport signal/bruit aux faibles niveaux, en injectant un signal de brouillage à une fréquence telle qu'il soit filtré par le filtre numérique de'sous-échantillonnage. Ce procédé augmente le rapport signal/bruit aux faibles niveaux, mais le dégrade aux forts niveaux.

La réalisation d'un codeur de type delta-sigma d'ordre 2 (ou à double intégration) a été proposée, notamment dans le brevet français n° 2 462 02 déjà cité. Dans ce document. le codeur est appliqué à une voie de transmission par modulations d'impulsions codées et les filtres de réaction et de contre-réaction qu'il utilise sont, pour l'essentiel, réalisés à partir de techniques nymériques. La réalisation de ce codeur a été effectuée après une étude comparative de différents codeurs delta-sigma du premier ordre, utilisant des techniques numériques; ces codeurs sont décrits, notamment dans l'article "A single PCM Codec" d'EVERARD-IEEE Journal of Solid State Circuits - vol. SC-14, 1er février 1979, et aussi dans l'article "Single-Chip per channel Codec with filters utilizing delta-sigma Modulations" de MISAWA, INERSEN, LOPORCADRO and RUCH - IEEE Journal of Solid-State Circuits vol. SC 16 - 4 août 1981.

L'étude de ces différentes réalisations montre que les performances atteintes sont insuffisantes pour que des systèmes de transmission utilisant ce type de codeurs puissent respecter correctement les normes imposées par le CCITT et, en particulier, l'avis G712 de ce Comité.

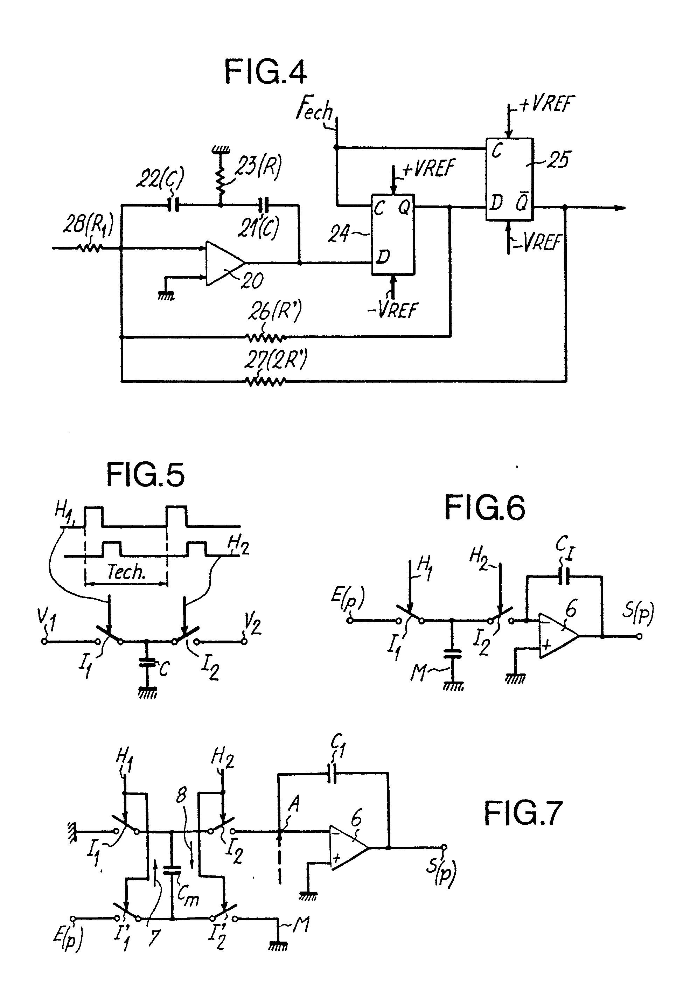

La figure 3 est un schéma de principe d'un codeur delta-sigma, à double intégration, de type connu, tel que décrit dans le brevet français n° 2 462 062 précité. Le codeur delta-sigma représenté sur cette figure comprend un premier additionneur 10 et un second additionneur 11. Le premier additionneur 10 reçoit d'une part le signal d'entrée E(Z) et, d'autre part, le signal Q(Z) de sortie du codeur. La sortie de ce premier additionneur est reliée à l'entrée d'un premier intégrateur 12. La sortie du premier intégrateur 12 est reliée à une entrée du second additionneur 11, qui reçoit à travers un filtre de contre-réaction 13 récursif d'ordre deux (multiplicateur par deux), le signal de sortie Q(Z) du codeur. La sortie du second additionneur 11 est reliée à une entrée d'un second intégrateur 14. Enfin, la sortie de ce second intégrateur est reliée à une entrée d'un circuit de quantification 15, commandé par un signal d'échantillonnage présentant une fréquence d'échantillonnage Fech. La sortie de ce circuit d'échantillonnage constitue la sortie du codeur delta-sigma à double intégration. Cette fonction de transfert est de la forme

$$F(p) = \frac{p + 2/\tau}{2\tau \cdot p^2}$$

comme indiqué dans la demande de brevet précitée. Dans cette relation, $\varphi$ = 1/Fech désigne la période d'échantillonnage.

Un exemple de réalisation d'un codeur delta-sigma d'ordre II n'utilisant qu'un seul amplificateur opérationnel, est décrit dans le brevet français FR-A- 2 462 062 précité. Ce codeur est représenté schématiquement sur la figure 4 et sa fonction de transfert est la suivante:

3

$$F\ (p)\ \underset{\sim}{}\ \frac{-2RC\ (p\ +\ \frac{1}{2RC})}{R_1\ RC^2\ p^2}$$

$$F\ (p)\ \underset{\sim}{}\ -\ (16R/R_1)\ \frac{p\ +\ \frac{1}{2RC}}{8R\ C\ p^2}\ =\ GF\ (p)$$

$$\text{qui devient } F\ (p)\ =\ \frac{p+2/\tau}{2\tau pe}$$

$$\text{en posant}\quad G\ =\ -\ 16\ (R/R_1)\quad \tau\ =\ 1/f_{ech} = 4RC$$

Le codeur delta-sigma à double intégration représenté sur cette figure comprend un amplificateur opérationnel 20, avec, dans sa voie de contre-réaction une cellule formée de deux condensateurs 21, 22 de capacité C, reliés en série, et d'une résistance en parallèle 23, de valeur R. La sortie de l'amplificateur opérationnel est reliée à deux bascules en cascade 24 et 25; les sorties de ces bascules sont reliées à l'entrée de l'amplificateur opérationnel 20 par des résistances 26 et 27 de valeurs respectives R' et 2R'. La valeur de la résistance 27 est le double de celle de la résistance 26 pour réaliser un codeur binominal. Les deux bascules 24 et 25, associees aux resitances 26 et 27, réalisent la fonction de transfert
$C\ (z)\ =\ 2 - z^{-1}$
La sortie de la deuxième bascule est faite sur $\bar{Q}$.
Les expériences montrent que si l'on choisit $R'\ =\ R_1$ ($R_1$ résistance d'entrée 28), la tension du filtre d'ordre deux atteint des valeurs trop élevées qui peuvent occasionner des blocages. Pour éviter cet inconvénient, au lieu de prendre
$C\ (z)\ =\ 2 - z^{-1}$,
on prend
$C\ (z)\ =\ 2\ (2 - z^{-1})$
Sur le schéma de la figure 4, Fech représente la fréquence d'échantillonnage des signaux d'echantillonnage appliqués sur les entrées C des bascules 24 et 25, de type D, tandis que + VREF et - VREF représentent des tensions de référence appliquées à ces bascules.
Ce montage est très sensible au bruit et la valeur des composants qu'il utilise le rend difficilement intégrable.
La présente invention a pour but de remédier à ces inconvénients et notamment, de réaliser un codeur de type delta-sigma, à double intégration, peu sensible au bruit, présentant des composants facilement intégrables. Ces buts sont atteints grâce à des sommateurs, des intégrateurs et des filtres (circuit multiplicateur) utilisant des montages à capacités commutées, notamment dans le codeur delta-sigma à double intégration, tel que décrit à la figure 3.
L'invention a pour objet un codeur analogique - numérique de type delta-sigma, à double intégration, comprenant un premier sommateur recevant, sur une première entrée, un signal à coder et recevant le signal codé sur une deuxième entrée, un premier intégrateur recevant sur une entrée un signal de sortie du premier sommateur, un deuxième sommateur recevant sur une première entrée, le signal d'une sortie du premier intégrateur, une deuxième entrée de ce deuxième sommateur recevant un signal présentant une amplitude moyenne proportionnelle à l'amplitude du signal codé, un deuxième intégrateur recevant sur une entrée le signal de sortie du deuxième sommateur, un circuit quantificateur dont une entrée est reliée à une sortie du deuxième intégrateur, et dont une entrée de commande reçoit un signal d'échantillonnage du signal à coder, une sortie de ce circuit quantificateur fournissant le signal codé, caractérisé en ce que le premier sommateur et le premier intégrateur comprennent un premier amplificateur opérationnel dont une sortie est reliée à une entrée négative de cet amplificateur par une capacité d'intégration, une entrée positive de ce premier amplificateur étant reliée à une masse de référence, et deux premiers circuits non inverseurs à capacités commutées reliés en parallèle sur les entrées du premier amplificateur opérationnel et recevant respectivement sur des entrées le signal à coder et le signal codé, le deuxième sommateur et le deuxième intégrateur comprenant un deuxième amplificateur opérationnel dont une sortie est reliée, d'une part à une entrée négative de cet amplificateur par une capacité d'intégration et est reliée, d'autre part, à l'entrée du circuit quantificateur une entrée positive de ce deuxième amplificateur étant reliée à la masse de référence et deux deuxièmes circuits non inverseurs à capacités commutées reliés en parallèle sur les entrées du deuxième amplificateur opérationnel et recevant respectivement sur des entrées le signal de sortie du premier amplificateur, et un signal d'amplitude moyenne proprotionnelle à l'amplitude du signal codé, chacun des

4

premiers circuits non inverseurs comprenant un premier jeu de deux interrupteurs connectés en série entre la masse de référence et l'entrée négative du premier amplificateur et un deuxième jeu de deux interrupteurs connectés en série entre la masse de référence et, respectivement, pour les premiers circuits non inverseurs une ligne fournissant le signal à coder, et la sortie du circuit quantificateur, une capacité de commutation reliant dans chacun des premiers circuits non inverseurs un point commun aux interrupteurs du premier jeu à un point commun aux interrupteurs du second jeu, chacun des deuxièmes circuits non inverseurs comprenant un premier jeu de deux interrupteurs connectes en série entre la masse de référence et l'entrée négative du deuxième amplificateur, et un deuxième jeu de deux interrupteurs connectés en série entre la masse de référence et, respecitvement, pour les deuxièmes circuits non inverseurs, la sortie du premier amplificateur et la sortie du circuit quantificateur, une capacité de commutation reliant un point commun aux interrupteurs du premier jeu à un point commun aux interrupteurs du deuxième jeu.

Selon une autre caractéristique, le codeur comprend en outre un circuit d'horloge fournissant deux trains d'impulsions de commande des ouvertures et fermetures des interrupteurs des circuits non inverseurs ces impulsions ayant une fréquence égale à une fréquence d'échantillonnage du signal à coder, l'un des interrupteurs de chaque jeu étant ouvert lorsque l'autre est fermé, et réciproquement.

Selon une autre caractéristique, le circuit quantificateur est une bascule de type D dont une entrée est reliée à la sortie du deuxième amplificateur une autre entrée de commande de cette bascule recevant les impulsions de l'un des trains, une sortie de cette bascule fournissant le signal codé.

Enfin selon d'autres caractéristiques, le codeur de l'invention s'applique àund chaîne de codage-décodage d'une voie de transmission de type MIC, ainsi qu'à la mesure de tensions continues.

Les caractéristiques et avantages de l'invention ressortiront mieux de la description qui va suivre, donnée en référence aux dessins annexes dans lesquels:

-la figure 1 qui a déjà été décrite représente schématiquement un codeur à mise en forme spectrale, de type connu;

- la figure 2 qui a déjà été décrite représente schématiquement un codeur de type delta-sigma d'ordre un, connu dans l'état de la technique;

- la figure 3 qui a déjà été décrite représente schématiquement un codeur de type delta-sigma, de type connu, d'ordre deux;

- la figure 4, déjà décrite représente une réalisation pratique, connue, du codeur de la figure 3;

- la figure 5 est un schéma de princpe d'un circuit à capacité commutée, équivalent à une résistance;

- la figure 6 es un schéma de principe d'un integrateur-inverseur à capacités commutées;

- la figure 7 est un schéma de principe d'un intégrateur non inverseur à capacités commutées utilisé dans le codeur de l'invention;

- la figure 8 est un schéma d'un codeur delta-sigma, à double intégration, conforme à l'invention, dans lequel les intégrateurs, sommateurs et filtres (multiplicateurs) utilisent des amplificateurs opérationnels et des capacités commutées;

- la figure 9 est une chaîne de codage-décodage d'une voie de transmission MIC à laquelle s'applique le codeur;

- la figure 10 est un montage par lequel le codeur de l'invention permet la mesure de tensions continues.

Les figures 1, 2, 3 et 4 ont déjà été décrites pour expliquer le principe de fonctionnement des codeurs à spectre de bruit et des codeurs de type delta-sigma; elles ne seront pas de nouveau décrites.

Comme on l'a mentionné plus haut, le codeur delta-sigma, à double intégration, de l'invention, utilise des intégrateurs et des sommateurs. à amplifcateurs opérationnels et capacités commutées.

La figure 5 représente schématiquement un circuit qui permet de simuler une résistance en commutant une capaité C entre deux sources de tension $V_1$ et $V_2$, grâce à deux interrupteurs $I_1$, $I_2$, reliés en série et recevant respectivement les tensions $V_1$, $V_2$; le point commun de ces interrupteurs est relié à l'une des bornes de la capacité C, l'autre borne de cette capacité étant reliée à une masse de référence M. Cette technique de simulation de résistance par commutations de capacités est bien connue, notamment dans les circuits intégrés MOS; elle est décrite notamment dans l'article "MOS SAMPLED DATA recursive filters using switched Capacitor Integrators" de HOSTICKA, BRODERSEN and GRAY. - IEEE Journal of Solid State Circuits, vol. SC-12, 6 décembre 1977.

Le circuit représenté sur cette figure fonctionne de la manière suivante:

Lorsque l'interrupteur $I_1$ est fermé (l'interrupteur $I_2$ étant ouvert), la charge de la capacité C est: $Q_1 = C.V_1$. Ensuite, l'interrupteur $I_2$ est fermé et l'interrupteur $I_1$ est ouvert; la charge de la capacité C est alors: $Q_2 = C.V_2$. Les ouvertures et fermetures des interrupteurs $I_1$ et $I_2$ peuvent etre par exemple commandées par des imulsions d'horloge $H_1$, $H_2$ de période Fech. Ces opérations d'ouverture et de fermeture sont répétées à une fréquence Fech. Pendant une période d'horloge Fech., une quantité de charge $Q = CV_1 - CV_2$ s'écoule de la source de tension $V_1$ vers la source de tension $V_2$; cette quantité de charge correspond à un courant moyen:

$$\bar{I} = C (V_1 - V_2). F.$$

Il en résulte que la capacité est équivalente à une résistance connectée entre les deux sources de tension $V_1$ et $V_2$. Cette résistance équivalente a pour valeur:

$$Req. = \frac{I}{C.Fech.}$$

La technique de simulation de résistance par capacités commutées peut être utilisée pour réaliser un circuit intégrateur-inverseur tel que représenté sur la figure 6. Cet intégrateur comprend, de manière connue, un amplificateur opérationnel 6 dont la borne positive est reliée à la masse de référence M; la sortie S(P) de cet amplificateur, qui constitue également la sortie de l'intégrateur-inverseur, est reliée à l'entrée négative de l'amplificateur opérationnel par l'intermédiaire d'une capacité d'intégration $C_1$. La résistance d'intégration qui est normalement reliée à l'entrée négative de l'amplificateur opérationnel, est ici simulée par un circuit à capacité commutée (décrit sur la figure 4), qui reçoit le signal E(P) à intégrer. Ce circuit comprend une capacité $C_m$ située entre la masse de référence M et le point commun aux deux interrupteurs $I_1$, $I_2$, commandés par les signaux d'horloge $H_1$, $H_2$. Si l'on suppose la fréquence maximum du signal utile S(P), très inférieure à la fréquence d'échantillonnage Fech., il est possible de remplacer directement dans la fonction de transfert de l'intégrateur, la résistance R normalement reliée à l'entrée négatine de l'amplificateur opérationnel 6, par son expression équivalente $Req. = 1/C_m$. Fech., obtenue grâce à la capacité $C_m$ et aux interrupteurs $I_1$, $I_2$. Si l'on désigne par Fech. la période du signal d'échantillonnage, la fonction de transfert du circuit intégrateur-inverseur représenté sur la figure, peut s'écrire:

$$H(P) = \frac{C_m}{C_I.Tech.} \cdot \frac{1}{P}$$

à condition que la fréquence F du signal d'entrée P(F) soit bien inférieure à la fréquence d'échantillonnage Fech.

$$= \frac{1}{Tech.} \cdot$$

L'avantage essentiel de ce circuit est de pouvoir remplacer le produit $R.C_1$ d'intégration dont les éléments sont difficilement intégrables de façon précise, tout en étant peu encombrants, par un rapport des capacités $C_m$ et $C_1$ qui peut être contrôlé de façon très précise, au cours d'un procédé de fabrication de circuits intégrés.

La figure 7 représente schématiquement un circuit intégrateur non inverseur, à capacités commutees, qui sera, comme on le verra plaus en détail, utilisé dans le codeur delta-sigma de l'invention. Ce circuit est une variante du circuit de la figure 5 dans lequel on inverse la charge avant de l'injecter vers l'entrée négative de l'amplificateur cpérationnel, qui luimême est monté en inverseur. Le circuit comprend, comme précédemment, un amplificateur opérationnel 6 dont la borne positive est reliée à une masse de référence M; la sortie S(P) de cet amplificateur, qui constitue également la sortie du circuit intégrateur, est reliée à l'entrée négative de l'amplificateur, par une capacité d'intégration $C_I$.

Dans ce montage, la capacité $C_m$ est associée a deux jeux d'interrupteurs $(I_1, I_2)$, $(I'_1, I'_2)$ dont les ouvertures et fermetures sont commandées par des signaux d'horloge $H_1$, $H_2$, à la fréquence d'échantillonnage Fech. Les interrupteurs $I_1$, $I_2$ sont reliés en série entre la masse de référence M et l'entrée négative de l'amplificateur opérationnel 6, leur point commun étant relié à l'une des bornes de la capacité $C_m$; les interrupteurs $I'_1$, $I'_2$ sont eux aussi reliés en série. L'une des bornes de l'interrupteur $I'_1$ reçoit le signal d'entrée E(P) et l'une des bornes de l'interrupteur $I'_2$ est reliée à la masse de référence M; le point commun aux deux interrupteurs est relié à une autre borne de la capacité $C_m$. Ce montage permet d'inverser la charge de la capacité $C_m$ avant de l'injecter à l'entrée de l'amplificateur 6. En effet, lorsque les interrupteurs $I_1$, $I'_1$ sont fermés, la capacité $C_m$ se charge dans le sens indiqué par la flèche 7, tandis que lorsque les interrupteurs $I_2$, $I'_2$ sont fermés, la capacité se charge dans le sens de la flèche 8 et la charge est donc inversée à l'entrée négative de l'amplificateur opérationnel monté en inverseur. Ce montage à capacité commutée est donc non inverseur et permet de simuler une résistance d'intégration à l'entrée de l'amplificateur opérationnel 6 et a pour principal avantage d'être insensible aux capacités parasites dues aux interrupteurs, précisément parce qu'il permet d'inverser la charge de la capacité $C_m$. Ces avantages sont d'ailleurs décrits dans l'article "Improved Circuits for the realization of Switched Capacitor filters" de MARTIN - IEEE Transaction on Circuit and Systems - vol CAS27 du 4 avril 1980.

Il est d'ailleurs possible de connecter plusieurs capacités commutées à l'entrée A de l'amplificateur opérationnel 6, de manière par exemple à réaliser des opérations de sommation, puis d'intégration. Dans ce cas, l'équation de la fonction de transfert de l'intégrateur-sommateur à m entrées, est de la forme;

$$H(Z) = \sum_{i=1}^{i=m} \frac{Cmi}{C_I} \cdot \frac{z^{-1/2}}{(1-z^{-1})}$$

La fonction de transfert H(P) de cet intégrateur-inverseur est la même que celle de l'intégrateur-inverseur de la figure 6.

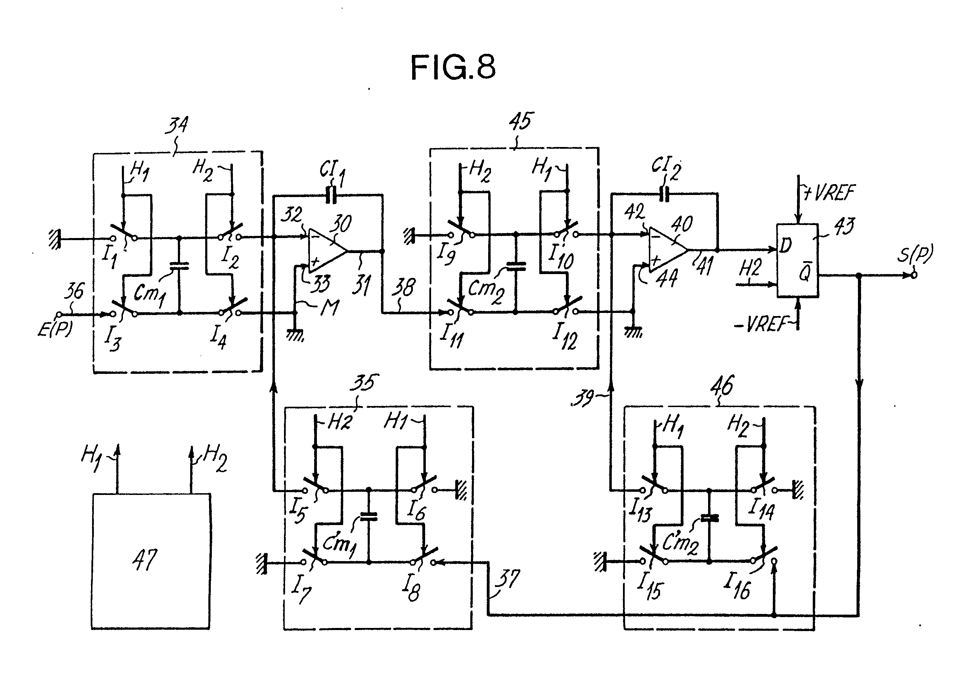

La figure 8 représente schématiquement un codeur de type delta-sigma, à double intégration, conforme à l'invention. Ce codeur comprend un premier sommateur-intégrateur recevant sur une première entrée 36 un signal E(P) à coder et sur une deuxième entrée 37 le signal codé de sortie S(P). Selon l'invention, le premier sommateur et le premier intégrateur comprennent un premier amplificateur opérationnel 30 dont une sortie 31 est reliée à une entrée négative 32 de cet amplificateur, par une capacité d'intégration $CI_1$. Une entrée positive 33 de ce premier amplificatcur est reliée à une masse de référence M. Ce premier intégrateur et ce premier sommateur comprennent aussi deux premiers circuits non inverseurs 34, 35 à capacités $Cm_1$, $C'm_1$, commutées. Ces deux premiers circuits non inverseurs sont reliés en parallèle sur les entrées 32, 33 du premier amplificateur opérationnel et reçoivent respectivement, sur des entrées, 38, 37 le signal E(P) à coder et le signal codé S(F) de sortie du codeur.

Ce codeur comprend aussi un deuxième sommateur-intégrateur recevant sur une première entrée 38 le signal de sortie du premier intégrateur-sommateur et sur une deuxième entrée 39, un signal dont l'amplitude moyenne est proportionnelle à l'amplitude du signal codé de sortie S(P). Le deuxième sommateur et le deuxième intégrateur comprennent un deuxième amplificateur opérationnel 40 dont une sortie 41 est reliée, d'une part, à une entrée négative 42 de cet amplificateur, par une capacité d'intégration $CI_2$, et d'autre part, à une entrée D d'un circuit quantificateur 43. Ce circuit quantificateur est constitué par une bascule de type D. Une entrée positive 44 du deuxième amplificateur 40 est reliée a la masse de référence M. Le deuxième sommateur et le deuxième intégrateur comprennent aussi deux deuxièmes circuits non inverseurs 45, 46 à capacités commutées $Cm_2$, $C'm_2$. Ces deux circuits non inverseurs sont reliés en parallèle sur les entrées 42, 44 du deuxième amplificateur 40. Ces circuits reçoivent respectivement, sur des entrées 38, 39, le signal de sortie du premier amplificateur 30 et un signal dont l'amplitude moyenne est proportionnelle à l'amplitude du signal codé. Le signal codé S(P) est obtenu sur la sortie complémentaire $\bar{Q}$ de la bascule D. Cette bascule comprend aussi une entrée de commande à laquelle sont appliqués des signaux $H_2$ d'un circuit d'horloge, qui seront décrits plus loin en détail. Des tensions de référence +VREF et -VREF sont appliquées aux deux autres entrées de cette bascule.

Chacun des premiers circuits non inverseurs 34, 35, comprend un premier jeu de deux interrupteurs connectés en série entre la masse de référence M et l'entrée négative 32 du premier amplificateur 30. Le premier jeu de deux interrupteurs est représenté en $I_1$, $I_2$, pour le circuit non inverseur 34, tandis que ce premier jeu d'interrupteurs est représenté en $I_5$, $I_6$, pour le circuit non inverseur 35.

Chacun des premiers circuits non inverseurs 34, 35, comprend aussi un deuxième jeu d'interrupteurs connectés en série entre la masse de referénce M et, respectivement, pour ces deux premiers circuits, l'entrée ou ligne 36 founnissant le signal E(P) à coder et la sortie $\bar{Q}$ du circuit quantificateur 43. Sur la figure les deuxièmes jeux d'interrupteurs sont représentés respectivement en $I_3$, $I_4$ et $I_7$, $I_8$. Le deuxième jeu d'interrupteurs $I_3$, $I_4$, est relié en série entre la masse da référence M et l'entrée ou ligne 36 fournissant le signal B(P) à coder. Le deuxième jeu d'interrupteurs $I_7$, $I_8$, est relié en série entre la masse de référence M et la sortie $\bar{Q}$ du circuit quantificateur 43. Dans chacun de ces premiers circuits non inverseurs 34, 35, une capacité de commutation relie un point commun aux interrupteurs du premier jeu à un point commun aux interrupteurs du second jeu. C'est ainsi que la capacité $Cm_1$ relie le point commun aux interrupteurs $I_1$, $I_2$, à un point commun aux interrupteurs $I_3$, $I_4$; la capacité $C'm_1$ relie un point commun aux interrupteurs $I_5$, $I_6$, à un point commun aux interrupteurs $I_7$, $I_8$.

Chacun des deuxièmes circuits non inverseurs 45, 46 comprend un premier jeu de deux interrupteurs, connectés en série entre la masse de référence M et l'entrée négative 42 du deuxième amplificateur 40; chacun de ces circuits comprend aussi un deuxième jeu de deux interrupteurs, connectés en série entre la masse de référence M et, respectivement, pour les deux deuxièmes circuits non inverseurs, la sortie 31 du premier amplificateur 30 et la sortie $\bar{Q}$ du circuit quantificateur 43.

Sur la figure, les premiers jeux de deux interrupteurs sont représentés respectivement en $I_9$, $I_{10}$ et $I_{15}$, $I_{16}$ pour les deuxièmes circuits inverseurs 45, 46; les deuxièmes jeux de deux interrupteurs sont représentés respectivement en $I_{11}$, $I_{12}$ et $I_{15}$, et $I_{18}$, pour les deuxièmes circuite non invereeure 45, 46. Dans chacun de ces circuits, une capacité de commutation relie un point commun aux interrupteurs du premier jeu à un point commun aux interrupteurs du deuxième jeu. C'est ainsi que la capacité $Cm_2$ relie un point commun aux Interrupteurs $I_9$, $I_{10}$, à un point commun aux interrupteurs $I_{11}$, $I_{12}$, et que la capacité $C'm_2$ relie un point commun aux interrupteurs $I_{13}$, $I_{14}$, à un point commun aux interrupteurs $I_{15}$, $I_{16}$.

Le codeur comprend aussi un circuit d'horloge 47 fournissant deux trains d'impulsions $H_1$, $H_2$, de commande des ouvertures et fermeture des interrupteurs de chacun des circuits non inverseurs 35, 36, 45, 46. Ces Impulsions ont été décrites plus haut, aux figures 5, 6, 7; les impulsions $H_2$ de l'un de ces trains d'impulsions sont aussi appliquées sur une entrée de commande de la bascule 43. En fait, cee impulsions ont une fréquence égale à la fréquence d'échantillonnage du signal à coder et elles agissent de manière que l'un des interrupteurs de chaque jeu soit ouvert lorsque l'autre est fermé, et réciproquement.

Le fonctionnement des deux paires de circuits sommateurs-intégrateurs constitués respectivement par l'amplificateur opérationnel 30, la capacité d'intégration $CI_1$, les deux premiers circuits non inverseurs 34, 35 et par l'amplificateur opérationnel 40, la capacité d'intégration $CI_2$, les deux deuxièmes circuits non inverseurs 45, 46, ne sera pas décrit ici en détail. Ce fonctionnement se déduit facilement des explications données à la figure 7 dans le cas où un second circuit inverseur est relié au point A représenté sur cette figure. L'amplitude moyenne du signal appliquée sur l'entrée négative 42 du deuxième amplificateur opérationnel 40, est proportionnelle à l'amplitude moyenne du signal codé F(P) de sortie du codeur. Cette proportionnalité est obtenue par un choix prédéterminé des valeurs des capacités $Cm_2$, $C'm_2$.

Les différents éléments du codeur qui vient d'être décrit sont facilement intégrables sur substrat. Ce codeur ne nécessite aucun artifice pour en assurer la statibilité ou le réglage. Il est en particulier très facilement intégrable par un procédé de fabrication utilisant une technique MOS.

La fonction de transfert de ce codeur s'obtient facilement à partir de l'équation en Z de la fonction de transfert d'un intégrateur à capacités commutées:

$$Q(Z) = \frac{Y_1 \cdot Y_2 \cdot E(Z) \cdot Z^{-1} + (1-Z^{-1})^2 \cdot N(Z)}{Z^{-2}(1 + \gamma'_1 \cdot Y_2 - \gamma'_2) + Z^{-1}(\gamma'_2 - 2) + 1}$$

avec $\gamma_1 = Cm_1/Cl1$
$\gamma_2 = Cm_2/Cl2$
$\gamma'_1 = C'm1/Cl1$
$\gamma'_2 = C'm2/Cl2$
La fonction du transfert est alors:
$H(Z) = (1 Z^{-1})^2$
Si on prend $\gamma1 = \gamma'_1 = 0,5$ et $\gamma2 = \gamma'_2$, on retrouve:
$Q(Z) = Z^{-1} \cdot E(Z) + (1-Z^{-1})^2 N(Z)$ qui est bien l'équation d'un codeur à mise en forme du spectre de bruit.

Une simulation complète de cette structure sur ordinateur ainsi que des mesures sur une maquette ont montré que dans ce cas, le gain en tension était trop élevé, ce qui entraînait des problèmes de saturation en sortie des amplificateurs opérationnels.

Différents essais ont alors montré qu'une solution du type:
$\gamma1 = 0,25$; $\gamma'1 = \gamma2 = 0,5$ et $\gamma'2 = 1$
représente un bon compromis entre les performances théoriques du codeur et les surtensions observées en sortie des amplificateurs opérationnels.

La fonction de transfert devient:

$$Q(Z) = \frac{1/8\ E(Z)\ Z^{-1} + N(Z)\ (1-Z^{-1})^2}{1/4\ Z^{-2} - Z^{-1} + 1} = Hp(Z)\left[ 1/8\ E(Z)\ Z^{-1} + N(Z)\ (1-Z^{-1})^2 \right]$$

Hp (Z) ne modifie pas le rapport signal/bruit du codeur dans une bande B de signal, mais amène une légère modification du spectre du signal d'entrée, mais il faut tenir compte du fait que la fréquence d'échantillonnage est très grande devant la fréquence maximum du signal à coder. Dans le cas de l'application du codeur à une voie MIC, le signal limité à une bande 300-3400 Hz est échantillonné à la fréquence de 2048 kHz et la variation d'atténuation apportée par Hp(Z) est inférieure à 0,02 décibels.

L'opération de quantification est réalisée par une simple bascule de type D. Ce type de circuit est tout à fait insensible à l'offset ou décalage de l'amplificateur opérationnel. En effet, cette tension de décalage peut être considérée comme faisant partie du bruit amené par l'opération de quantification et donc, de ce fait, affectée par la fonction de filtrage H(Z) qui présente une atténuation théorique infinie à la fréquence 0.

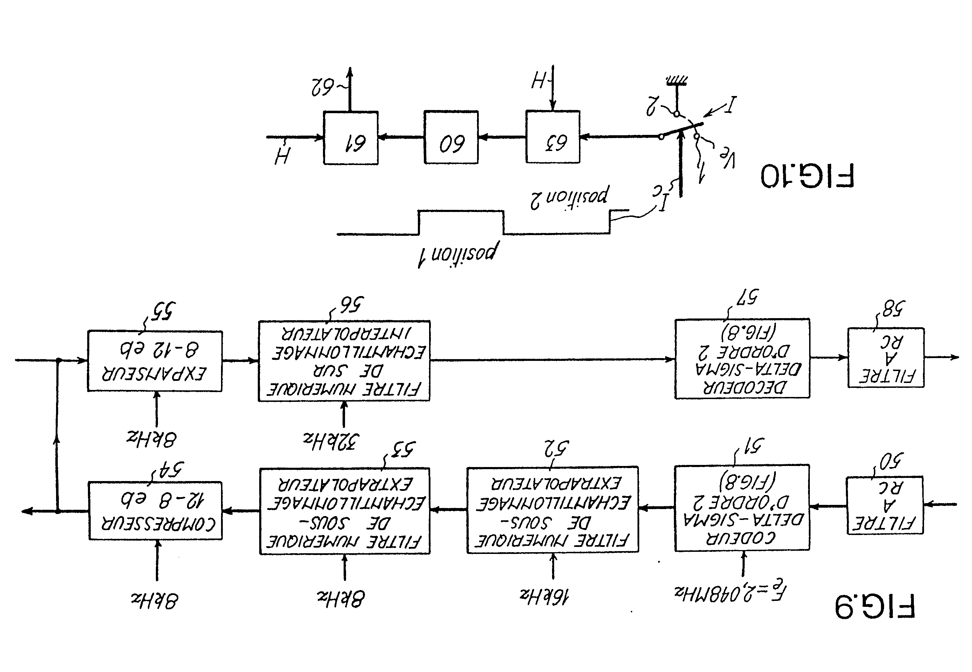

Comme on l'a indiqué plus haut, le codeur de l'invention peut s'appliquer à une chaîne de codage -décodage d'une voie de transmission de type MIC. Cette chaîne est représentée sur la figure 9 et elle est décrite dans le brevet français n° 2 462 062 précité. Le codeur delta-sigma d'ordre deux, représenté dans cette chaîne est en fait le codeur de l'invention, qui a été décrit à la figure 8.

La chaîne comprend un codeur analogique-MIC et un décodeur MIC analogique par canal unique de transmission.

Le codeur MIC-analogique comprend un filtre 50 à résistance-capacité, un codeur delta sigma 51, du second ordre, à double intégration, qui est d'un type conforme à celui de l'invention et qui fonctionne à 2,048 MHz, un premier filtre numérique 52 de sous-échantillonnage fonctionnant à 16 kHz, un second filtre numérique 53 de sous-échantillonnage fonctionnant à 8 kHz et un compresseur 54, 12eb - 8eb (eb = éléments binaires).

Le déccdeur HIC comprend un expanseur 55, 8eb - 12eb, fonctionnant à 8 kHz, un filtre numérique 56 interpolateur de sur-échantillonnage, fonctionnant à 32 kHz, un décodeur delta-sigma 57 d'ordre 2 à double intégration numérique, conforme à l'invention, fonctionnant à 2,048 MHz, et un filtre 58 à Résistance-Capacité.

Le codeur de l'invention s'applique aussi à la mesure de tensions continues. Dans un codeur delta-sigma d'ordre 2, le bruit N(Z) amené par l'opération de quantification est filtré par la fonction $H(Z) = (1-Z^{-1})^2$; fonction dont le module est proportionnel à $(\sin 2\pi f.T)^2$; T étant la période du signal d'échantillonnage et f la fréquence où l'on effectue la mesure.

Le codeur amène une atténuation infinie sur le bruit de quantification à la frequence zéro. Il est donc possible d'effectuer des mesures de composantes continues très fines avec un matériel peu coûteux.

La figure 10 montre un exemple de réalisation d'un convertisseur analogique-numérique continu utilisant un codeur 43, conforme à l'invention. Le filtrage numérique est réduit à sa plus simple expression, c'est-à-dire une simple accumulation de données dans un accumulateur 60.

0 104 988

On sait que la fonction de transfert amenée par l'accumulation (addition de $\underline{n}$ données successives au fur et à mesure de leur arrivée, puis remise à zéro de l'accumulateur et nouvelle accumulation sans perte d'information), est de la forme:

$$H(Z) = \frac{1-Z^{-(n+1)}}{1-Z^{-1}}$$

Dans ce cas, le signal de sortie du codeur 63, est échantillonné à la fréquence F/n, F étant la fréquence d'arrivée des échantillons dans l'accumulateur 60.

Dans le cas d'une application en mesure de tension absolue, il faut d'abord s'affranchir des imperfections du codeur et notamment de l'offset ou décalage amené par le codeur et qui ne pourrait pas être différencié de la mesure du signal Ve d'entrée. Dans ces conditions, la mesure doit se faire en deux temps:

- mesure du décalage ou offset du codeur 61, en fermant l'entrée sur la masse M. L'interrupteur I est mis dans la position 2 et on mémorise le résultat obtenu par l'unité arithmétique et logique 61, en fin de cette première accumulation;

- mesure du signal proprement dit, en reliant l'entrée du codeur a la source Ve a mesurer (position 1 de l'interrupteur I) et en initialisant l'accumulateur (60) avec le résultat de la première accumulation après inversion, ou en soustrayant au résultat de l'accumulation obtenue avec Ve, celui de la première accumulation (traitements effectués par l'unité 61).

Sur cette figure $I_c$ est un signal de commande de l'interrupteur I, et H des signaux d'horloge de commande de l'unité 61 et du codeur delta-sigma 63. Si Tm désigne la période des signaux Ic, la fréquence $F_H$ des signaux H doit être bien superieure à

$$\frac{1}{Tm}.$$

Les résultats des mesures sont obtenus sur la sortie 62 de l'unité 61.

## Revendications

1. Codeur analogique-numérique de type delta-sigma, à double intégration, comprenant un premier sommateur recevant, sur une première entrée (36), un signal E(p) à coder et recevant le signal codé (Sp) sur une deuxième entrée (37), un premier intégrateur recevant sur une entrée (32), un signal de sortie du premier sommateur, un deuxième sommateur recevant sur une première entrée (38), le signal d'une sortie (31) du premier intégrateur, une deuxième entrée 39 de ce deuxième sommateur recevant un signal présentant une amplitude moyenne proportionnelle à l'amplitude du signal codé, un deuxième intégrateur recevant sur une entrée (42) le signal de sortie du deuxième sommateur, un circuit quantificateur (43) dont une entrée (D) est reliée à une sortie (41) du deuxième intégrateur, et dont une entrée de commande reçoit un signal $(H_2)$ d'échantillonnage du signal (EP) à coder une sortie $\bar{Q}$ de ce circuit quantificateur fournissant le signal codé S(p), caractérisé en ce que le premier sommateur et le premier intégrateur comprennent un premier amplificateur opérationnnel (30) dont une sortie (31) est reliée à une entrée négative (32) de cet amplificateur par une capacité d'intégration (CI1), une entrée positive (33) de ce premier amplificateur étant reliée à une masse de référence (M), et deux premiers circuits non inverseurs (34, 35) à capacités commutées ($Cm_1$, $C'm_1$) reliés en parallèle sur les entrées (32, 33) du premier amplificateur opérationnel et recevant respectivement sur des entrées (36, 37) le signal à coder E(p) et le signal codé (Sp), le deuxième sommateur et le deuxième intégrateur comprenant un deuxième amplificateur opérationnel dont une sortie est reliée, d'une part à une entrée négative de cet amplificateur par une capacité d'intégration et est reliée, d'autre part, à l'entrée (D) du circuit quantificateur (43), une entrée positive (44) de ce deuxième amplificateur (40) étant reliée à la masse (M) de référence, et deux deuxièmes circuits non inverseurs (45, 46) à capacités commutées ($Cm_2$, $C'm_2$) reliés en parallèle sur les entrées (42, 44) du deuxième amplificateur opérationnel et recevant respectivement sur des entrées (38, 39) le signal de sortie du premier amplificateur (30) et un signal d'amplitude moyenne proportionnelle à l'amplitude du signal codé, chacun des premiers circuits non inverseurs (34, 35) comprenant un premier jeu de deux interrupteurs ($I_1$, $I_2$ et $I_5$, $I_6$) connectés en série entre la masse de référence (M) et l'entrée négative (32) du premier amplificateur (30) et un deuxième jeu de deux interrupteurs $I_3$, $I_4$ et $I_7$, $I_8$) connectés en série entre la masse de référence (M) et, respectivement, pour les premiers circuits non inverseurs (34, 35), une ligne (36) fournissant le signal E(p) à coder, et la sortie $(\bar{Q})$ du circuit quantificateur (43), une capacité ($Cm_1$, $Cm_2$) de commutation reliant dans chacun des premiers circuits non inverseurs un point commun aux interrupteurs du premier jeu à un point commun aux interrupteurs du second jeu, chacun des deuxièmes circuits non inverseurs (45, 46) comprenant un premier jeu de deux interrupteurs ($I_9$, $I_{10}$ et $I_{13}$, $I_{14}$) connectée en série entre la masse de référence (M) et l'entrée négative (42) du deuxième amplificateur (40), et un deuxième jeu de deux interrupteurs ($I_{11}$, $I_{12}$ et $I_{15}$, $I_{16}$) connectés en série entre la masse de référence (M) et,

9

respectivement, pour les deuxièmes circuits non inverseurs (45, 46), la sortie (31) du premier amplificateur (30) et la sortie ($\bar{Q}$) du circuit quantificateur (43), une capacité de commutation ($Cm_2$ ou $C'm_2$) reliant un point commun aux interrupteurs du premier jeu à un point commun aux interrupteurs du deuxième jeu.

2. Codeur selon la revendication 1, caractérisé en ce qu'il comprend en outre un circuit d'horloge (47) fournissant deux trains d'impulsions ($H_1$, $H_2$) de commande des ouvertures et fermetures des interrupteurs des circuits non inverseurs 35, 36, 45, 46), ces impulsions ayant une fréquence égale à une fréquence d'échantillonnage du signal à coder, l'un des interrupteurs de chaque jeu étant ouvert lorsque l'autre est fermé, et réciproquement.

3. Codeur selon la revendication 2, caractérisé en ce que le circuit quantificateur (43) est une bascule de type D dont une entrée (D) est reliée à la sortie du deuxième amplificateur (40), une autre entrée de commande de cette bascule recevant les impulsions ($H_2$) de l'un des trains, une sortie ($\bar{Q}$) de cette bascule fournissant le signal codé.

4 . Application du codeur conforme à l'une quelconque des revendications 1 à 3, à une chaîne de codage-déccdage d'une voie de transmission de type MIC.

5. Ensemble de mesure de tension continue comprenant un codeur (63) conforme à l'une quelconque des revendications 1 à 3, un interrupteur (I) alternativement ouvert et fermé à une fréquence

$$\frac{1}{T_m}$$

pour appliquer périodiquement une tension continue (Ve) à mesurer sur une entrée du codeur, ce codeur recevant un signal d'échantillonnage à une fréquence $F_H$ bien supérieure à la fréquence d'ouverture et de fermeture de l'interrupteur, un accumulateur de données (60) relié à la sortie du codeur, et une unité arithmétique et logique (61) reliée à une sortie de l'accumulateur (60) cette unité recevant le signal d'échantillonnage à la fréquence $F_H$ et fournissant sur une sortie la valeur de la tension (Ve) à mesurer.

**Claims**

1. Double integration delta-sigma type analogue-digital coder including a first summer receiving, on a first input (36) a signal E(p) to be coded and receiving the coded signal (Sp) on a second input (37), a first integrator receiving on an input (32) an output signal from the first summer, a second summer receiving on a first input (38) the signal from an output (31) of the first integrator, a second input (39) of this second summer receiving a signal having a mean amplitud proportional to the amplitude of the coded signal, a second integrator receiving on an input (42) the output signal of the second summer, a quantizing circuit (43) of which one input (D) is connected to an output (41) of the second integrator, and of which one control input receives a sampling signal ($H_2$) of the signal to be coded (EP), one output Q of this quantizing circuit providing the coded signal S(p), characterized in that the first summer and the first integrator include a first operational amplifier (30) of which an output (31) is connected to a negative input (32) of this amplifier through an integrating capacitor (CI1), a positive input (33) of this first amplifier being connected to a reference ground (M), and two first non-inverting ciccuits (34, 35) with switched capacitors ($Cm_1$, $C'm_1$) connected in parallel to the inputs (32, 33) of the first operational amplifier and receiving the signal to be coded E(p) and the coded signal (Sp) respectively on the inputs (36, 37), the second summer and the second integrator including a second operational amplifier of which an output is connected on the one hand to a negative input of this amplifier through an integrating capacitor and on the other hand is connected to the input (D) of the quantizing circuit (43), a positive input (44) of this second amplifier (40) being connected to the reference ground (M), and two second non-inverting circuits (45, 46), with switched capacitors ($Cm_2$, $C'm_2$) connected in parallel to the inputs (42, 44) of the second operational amplifier and receiving the output signal of the first amplifier (30) and a signal of mean amplitude proportional to the amplitude of the coded signal respectively on inputs (38, 39), each of the first non-inverting circuits (34, 35) including a first set of two switches ($I_1$, $I_2$ and $I_5$, $I_6$) connected in series between the reference ground (M) and the negative input (32) of the first amplifier (30) and a second set of two switches ($I_3$, $I_4$ and $I_7$, $I_8$) connected in series between the reference ground (M) and, for the first non-inverting circuits (34, 35) respectively, a line (36) providing the signal E(p) to be coded, and the output ($\bar{Q}$) of the quantizing circuit (43), a switched capacitor ($Cm_1$, $Cm_2$) in each of the first non-inverting circuits connecting a point common to the switches of the first set to a point common to the switches of the second set, each of the second non-inverting circuits (45, 46) including a first set of two switches ($I_9$, $I_{10}$ and $I_{13}$, $I_{14}$) connected in series between the reference ground (M) and the negative input (42) of the second amplifier (40), and a second set of two switches ($I_{11}$, ($I_{12}$ and $I_{15}$, $I_{16}$) connected in series between the reference ground (M) and, for the second non-inverting circuits (45, 46) respectively, the output (31) of the first amplifier (30) and the output ($\bar{Q}$) of the quantizing circuit (43), a switched capacitor ($Cm_2$ or $C''m_2$) connecting a point common to the switches of the first set to a point common to the switches of the second set.

2. Coder according to Claim 1, characterized in that it also includes a clock circuit (47) providing two trains of pulses ($H_1$, $H_2$) to control the opening and closing of the switches of the non-inverting circuits (35, 36, 45, 46), these pulses having a frequency equal to a sampling frequency of the signal to be coded, one of the switches in each set being open while the other is closed, and vice versa.

3. Coder according to Claim 2, characterized in that the quantizing circuit (43) is a D-type flip-flop of which one input (D) is connected to the output of the second amplifier (40), another control input of the flip-flop receiving the pulses ($H_2$) of one of the trains, an output (Q) of this flip-flop providing the coded signal.

4. Application of the coder according to any of Claims 1 to 3, to a coding-decoding system in a PCM-type transmission channel.

5. D.c. voltage measuring assembly including a coder (63) according to any of Claims 1 to 3, a switch (I) alternately open and closed at a frequency $1/T_m$ in order to periodically apply a d.c. voltage (Ve) to be measured to an input of the coder, this coder receiving a sampling signal at a frequency $F_H$ much greater than the frequency of opening and closing the switch, a data accumulator (60) connected to the output of the coder, and an arithmetic and logic unit (61) connected to one output of the accumulator (60), this unit receiving the sampling signal at the frequency $F_H$ and providing on an output the value of the voltage (Ve) to be measured.

**Patentansprüche**

1. Delta-Sigma-Analog/Digital-Kodierer mit doppelter Integration, enthaltend einen ersten Summierer, der an einem ersten Eingang (36) ein zu kodierendes Signal E(p) empfängt und das kodierte Signal S(p) an einem zweiten Eingang (37) empfängt, einen ersten Integrator, der an einem Eingang (32) ein Ausgangssignal des ersten Summierers empfängt, einen zweiten Summierer, der an einem ersten Eingang (38) das Signal eines Ausgangs (31) des ersten Integrators empfängt, wobei ein zweiter Eingang (39) dieses zweiten Summierers ein Signal empfängt, das eine mittlere Amplitude hat, die proportional der Amplitude des kodierten Signals ist, einen zweiten Integrator, der an einem Eingang (42) das Ausgangssignal des zweiten Summierers empfängt, einen Quantisierkreis (43), dessen einer Eingang (D) mit einem Ausgang (41) des zweiten Integrators verbunden ist, und dessen einer Steuereingang ein Abtastsignal ($H_2$) des zu kodierenden Signals E(p) erhält, wobei ein Ausgang dieses Quantisierkreises das kodierte Signal S(p) liefert, dadurch gekennzeichnet, daß der erste Summierer und der erste Integrator einen ersten Operationsverstärker (30) enthalten, dessen einer Ausgang (31) mit einem negativen Eingang (32) dieses Verstärkers über einen Integrationskondensator (Cl1) verbunden ist, wobei ein positiver Eingang (33) dieses ersten Verstärkers mit einer Bezugsmasse (M) verbunden ist, und zwei erste nicht-invertierende Schaltungen (34, 35) geschalteter Kapazitäten ($Cm_1$, $C'm_1$), die parallel über die Eingänge (32, 33) des ersten Operationsverstärkers geschaltet sind und jeweils Ober Eingänge (36, 37) das zu kodierende Signal E(p) und das kodierte Signal S(p) erhalten, der zweite Summierer und der zweite Integrator einen zweiten Operationsverstärker enthalten, dessen einer Eingang einerseits mit einem negativen Eingang dieses Verstärkers über einen Integrationskondensator verbunden ist und andererseits mit dem Eingang (D) des Quantisierkreises (43) verbunden ist, ein positiver Eingang (44) des zweiten Verstärkers (40) mit der Bezugsmasse (M) verbunden ist, und zwei zweite nicht-invertierende Schaltungen (45, 46) geschalteter Kapazitäten ($Cm_2$, $C'm_2$) parallel über die Eingänge (42, 44) des zweiten Operationsverstärkers geschaltet sind und jeweils über Eingänge (38, 39) das Ausgangssignal des ersten Verstärkers (30) und ein Signal mittlerer Amplitude erhalten, die proportional der Amplitude des kodierten Signals ist, jede der ersten nicht-invertierenden Schaltungen (34, 35) einen ersten Satz aus zwei Unterbrechern ($I_1$, $I_2$ und $I_5$, $I_6$) enthalted, die in Serie zwischen die Bezugsmasse (M) und den negativen Eingang (32) des ersten Verstärkers (30) geschaltet sind, und einen zweiten Satz aus zwei Unterbrechern ($I_3$, $I_4$ und $I_7$, $I_8$), die in Serie zwischen die Bezugsmasse (M) und den Ausgang ($\bar{Q}$) des Quantisierkreises (43) geschaltet sind, wobei jeweils für die ersten nicht-invertierenden Schaltungen (34, 35) eine Leitung (36) das zu kodierende Signal E(p) liefert, wobei eine geschaltete Kapazität ($Cm_1$, $Cm_2$) in jeder der ersten nicht-invertierenden Schaltungen einen den Unterbrechern des ersten Satzes gemeinsamen Punkt mit einem den Unterbrechern des zweiten Satzes gemeinsamen Punkt verbindet, jede der zweiten nicht-invertierenden Schaltungen (45, 46) einen ersten Satz aus zwei Unterbrechern ($I_9$, $I_{10}$ und $I_{13}$, $I_{14}$) aufweist, die in Serie zwischen die Bezugsmasse (M) und den negativen Eingang (42) des zweiten Verstärkers (40) geschaltet sind, und einen zweiten Satz aus zwei Unterbrechern ($I_{11}$, $I_{12}$ und $I_{15}$, $I_{16}$) aufweist, die in Serie zwischen die Bezugsmasse (M) und jeweils für die zweiten nicht-invertierenden Schaltungen (45, 46) den Ausgang (31) des zweiten Verstärkers (30) und den Ausgang ($\bar{Q}$) des Quantisierkreises (43) geschaltet sind, wobei eine Schalthapazität ($Cm_2$ oder $C'm_2$) einen den Unterbrechern des ersten Satzes gemeinsamen Punkt mit einem den Unterbrechern des zweiten Satzes gemeinsamen Punkt verbindet.

2. Kodierer nach Anspruch 1, dadurch gekennzeichchnet, daß er weiterhin eine Taktgeneratorschaltung (47) enthält, die zwei Impulszüge ($H_1$, $H_2$) zur Steuerung der Öffnung und der Schließung der Unterbrecher der nicht-invertierenden Schaltungen (35, 36, 45, 46) enthält, wobei diese Impulse eine Frequenz haben, die gleich einer Abtastfrequenz des zu kodierenden Signals ist, wobei einer der Unterbrecher eines jeden Satzes offen ist, wenn der andere geschlossen ist, und umgekehrt.

3. Kodierer nach Anspruch 2, dadurch gekennzeichnet, daß der Quantisierkreis (43) eine D-Typ-Kippschaltung ist, deren einer Eingang (D) mit dem Ausgang des zweiten Verstärkers (40) verbunden ist, wobei ein anderer Steuereingang dieser Kippschaltung die Impulse ($H_2$) des einen der Züge erhält und ein Ausgang ($\bar{Q}$) dieser Kippschaltung das kodierte Signal liefert.

4. Anwendung des Kodierers nach einem der Ansprüche bis 3 auf eine Kodier-Dekodier-Kette einer PCM- übertragungsstrecke.

5. Anordnung zum Messen von Gleichspannung, enthaltend einen Kodierer (63) nach einem der Ansprüche 1 bis 3, einen Unterbrecher (I), der alternativ mit einer Frequenz 1/Tm geöffnet und geschlossen ist, um periodisch eine zu messende Gleichspannung (Ve) über einen Eingang des Kodierers anzulegen, wobei dieser Kodierer ein Abtastsignal mit einer Frequenz $F_H$ erhält, die gut oberhalb der Öffnungs- und Schließfrequenz des Unterbrechers liegt, wobei ein Datenspeicher (60) an den Ausgang des Kodierers angeschlossen ist und eine arithmetische und logische Einheit (61) mit einem Ausgang des Speichers (60) verbunden ist, wobei diese Einheit das Abtastsignal der Frequenz $F_H$ erhält und an einem Ausgang den Wert der zu messenden Spannung (Ve) abgibt.

FIG.1

FIG.2

FIG.3

# FIG.4

# FIG.5

# FIG.6

# FIG.7

FIG.8

## FIG.9

$F_e = 2,048 MHz$

| | 16kHz | 8kHz | 8kHz |

FILTRE A RC
50

CODEUR DELTA-SIGMA D'ORDRE 2 (FIG.8)
51

FILTRE NUMERIQUE DE SOUS-ECHANTILLONNAGE EXTRAPOLATEUR
52

FILTRE NUMERIQUE DE SOUS-ECHANTILLONNAGE EXTRAPOLATEUR
53

COMPRESSEUR 12-8 eb
54

32kHz

8kHz

FILTRE A RC
58

DECODEUR DELTA-SIGMA D'ORDRE 2 (FIG.8)
57

FILTRE NUMERIQUE DE SUR ECHANTILLONNAGE INTERPOLATEUR
56

EXPANSEUR 8-12 eb
55

## FIG.10

position 1

$I_c$

position 2

$V_e$

1

$I$

2

63

60

61

$H$

$H$

$62$

0 104 988